# EUROPEAN PATENT SPECIFICATION

(11) **EP 0 370 511 B1**
(45) Date of publication and mention of the grant of the patent: **12.03.1997**
(21) Application number: 89121678.0
(22) Date of filing: 23.11.1989
(51) Int. Cl.: G03F 1/16, G03F 1/14

(54) **Method of fabricating a photoplate**
Photomasken-Herstellungsverfahren
Procédé de fabrication d'un photomasque

(30) Priority: 24.11.1988 JP 296956/88
(43) Date of publication of application: 30.05.1990
(73) Proprietor: KABUSHIKI KAISHA TOSHIBA, Kawasaki-shi, Kanagawa-ken 210 (JP)
(72) Inventor: Yamamoto, Noboru, Kawasaki-shi kanagawa-ken (JP); Matsuoka, Yasuo, Nakahara-ku Kawasaki-shi Kanagawa-ken (JP)
(74) Representative: Lehn, Werner, Dipl.-Ing.

(56) References cited:
- PATENT ABSTRACTS OF JAPAN, vol. 7, no. 136 (E-181)(1281) 14 June 1983 & JP-A-58 50 739
- PATENT ABSTRACTS OF JAPAN, vol. 6, no. 226 (E-141)(1104) 11 November 1982 & JP-A-57 128 032

## Description

### BACKGROUND OF THE INVENTION

The present invention relates to a photomask used in producing semiconductor devices, and more particularly relates to a method of fabricating a photoplate and a photoplate fabricated by the method.

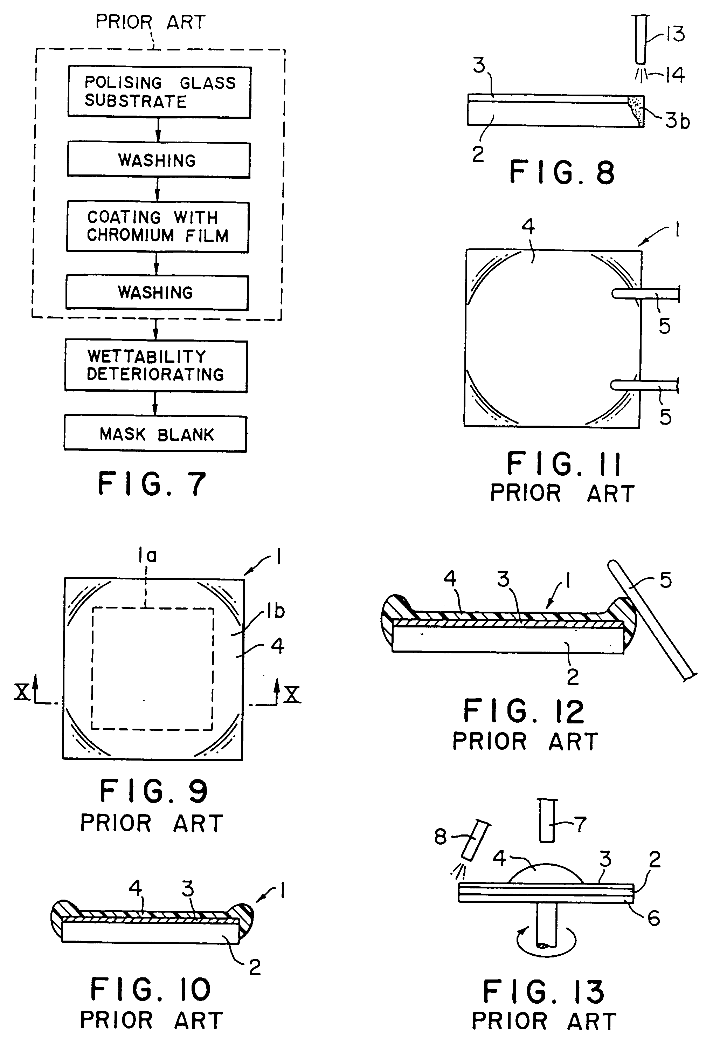

A photomask is used in the photoengraving process of the manufacture of integrated circuits. As shown in FIGS. 9 and 10, to fabricate the photomask a chromium film is deposited on a glass substrate 2 and then an electron beam resist is applied over the chromium film 3 to form a resist coating 4. The resist coating 4 of the photoplate 1 is exposed to an electron beam or the like and then a pattern is etched in the chromium film. More specifically, to produce the photoplate 1, the glass substrate 2 is polished, washed, and then coated with a chromium film 3. The resulting mask blank is cleaned. The resist is applied over the whole surface of the chromium film 3 of the mask blank while the mask blank is rotated, and hence that resist coating 4 covers as far as a marginal area 1b of the photoplate 1. No pattern is formed in the marginal area 1b which surrounds a central pattern forming area 1a.

The resist coating 4 of the marginal area 1b produces the following disadvantage which deteriorates yield and quality of the photomask. That is, to prevent charging of the photomask 1 during forming of a pattern in the photoplate 1 by means of an electron beam scanner, the chromium film 3 is, as shown in FIG. 11, earthed through earth pins 5 and 5 or the like earthing members. As illustrated in FIG. 12, the resist film 4 of the marginal area 1b can interpose between the earth pins 5 and 5 and the chromium film 3, thus preventing the earth pins 5 and 5 from electrically contacting the chromium film 3. For this reason, two earth pins 5 and 5 are usually used so that at least one earth pin is in electrical contact with the chromium film 3. However, imperfect electrical connection between the earth pins 5 and 5 and the chromium film 3 can cause excessive charging of the photoplate1, thus providing adverse affects to the photomask in yield and quality thereof. The same is also the case in detecting termination of development of the resist film 4 by sensing an electric characteristic of the photoplate 1 after electron beam exposure.

To solve this problem, there is proposed the so-called edge cutting, in which a mask blank is placed on a rotating disk 6. To apply a resist, it is dropped on a chromium film 3 of the mask blank on the rotating disk 6 from a resist nozzle 7 at a position just above the center of the rotating disk 6 while that rotating disk 6 is rotated. During the application of the resist, a pressurized gas gas or a resist solvent is sprayed from another nozzle 8 to the marginal area 1a of the chromium film 2 to prevent the resist from adhering to that marginal area 1a. However, the pressurized gas spraying unit or the solvent spraying unit makes the resist applying system rather complicated. Furthermore, the resist solution can adhere to the pattern forming area 1b by splashing it from the marginal area la, thus degrading the quality of the photomask.

Another attempt to solve the problem is that after the resist is applied, a particular step, for example, a resist removing step is added to remove the resist at portions of the marginal area 1b of the photoplate 1 for electrical contact with earth pins 5. This method considerably complicates the fabrication of the photoplate 1.

JP-A-57-128032 discloses a system for preventing a mask or a wafer from being covered with resist material employing a mechanical masking device pressed by a spring to the peripheral corner of the mask or wafer before a resist is covered on the mask wafer. This way, since the resist is not covered on the region masked by the device, this region can be grounded.

JP-A-58-50793 describes a method of preventing a registration mark on a wafer from being coated with a resist by coating the mark portion with a 0.5% methanol solution of a fluorine-system surface active agent.

The object of the present invention it to provide an uncomplicated method for fabricating a photoplate, in which a part of the photoplate does not become covered by resist.

This object is solved by a method having the features described in claim 1.

The method according to the present invention provides a photoplate, which enables positive earthing of the electrically conductive opaque film, without using any complicated system.

### BRIEF DESCRIPTION OF THE DRAWINGS

The present invention will now be described by way of example with reference to the drawings:
FIG. 1 is a plan view of a photoplate, in which a conductive film is grounded by means of an earth pin;
FIG. 2 is a view taken along the line II-II in FIG. 1;
FIG. 3 is a perspective view of a packing case in which mask blanks are accommodated for contaminating the chromium films with a wettability deteriorating material;
FIG. 4 is a view taken along the line IV-IV in FIG. 3;
FIG. 5 is a view taken along the line V-V in FIG. 4;
FIG. 6 is an enlarged plan view of one of finished photoplates;
FIG. 7 is a flow chart showing how to fabricate photoplates according to the present invention;
FIG. 8 is a schematic side view illustrating how to contaminate a mask blank with a wettability deteriorating gas according to the present invention;
FIG. 9 is a plan view of a photoplate produced according to the prior art;
FIG. 10 is a view taken long the line IX-IX in FIG. 9;
FIG. 11 is a plan view of a photoplate of the prior art with earth pins provided;
FIG. 12 is an enlarged vertical section of the photplate of FIG. 11; and
FIG. 13 is a side view showing how to produce a photoplate according the edge cutting method of the prior art.

### DETAILED DESCRIPTION OF THE PREFERRED EMBODIMENTS

Referring now to the drawings, like reference characters designate corresponding parts, already described, of the photoplate of FIGS. 11 and 12 throughout several views.

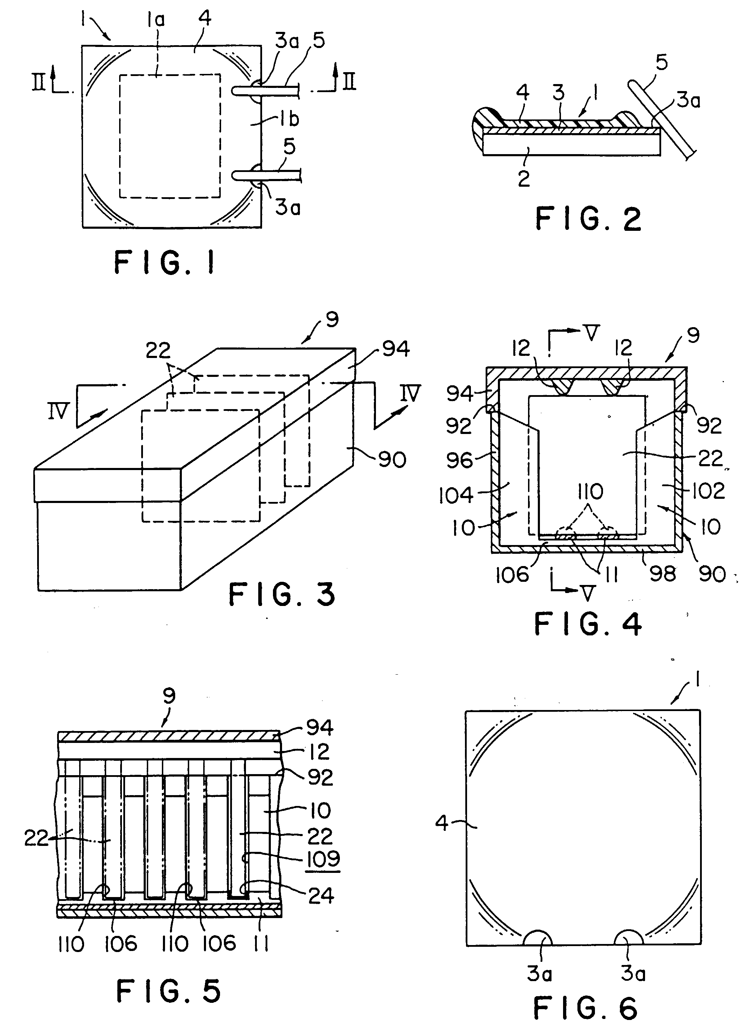

As shown in FIGS. 1 and 2, a photoplate 1 also includes a glass substrate 2, an electrically conductive, opaque chromium film 3 deposited on an upper surface of the glass substrate 2, and an electron beam resist film 4 covering an upper surface of the chromium film 3. In a pattern forming area 1a of the photoplate 1, the chromium film 3 has a pair of exposed zones 3a and 3a formed at its one side of a marginal area 1b thereof. The exposed zones 3a and 3a are not covered with the electron beam resist film 4 and are placed in electrical contact with respective earth pins 5 and 5.

In forming a pattern in the resist film 4 by means of electron beam lithography, the photoplate 1 is prevented from being electrostatically charged by earthing the chromium film 3 through the earth pins 5 and 5. Sufficient electrical contact of the earth pins 5 and 5 with corresponding exposed zones 3a and 3a of the chromium film 3 positively prevents charging of the photoplate 1.

The exposed zones 3a and 3a are generally formed by the following manner. First, portions of the chromium film 3 is contaminated by a wettability deteriorating material , such as a material including fluorine, to deteriorate wettability thereof to the resist. Then, the electron beam resist is applied over the whole upper surface of the chromium film 3 to form the resist film 4, so that the exposed zones 3a and 3a are formed because of deteriorated wettability thereof.

FIGS. 3 to 6 illustrate how to produce such a photoplate. Mask blanks 22 or glass substrates 2 which have each a chromium film 3 deposited are received in a packing case 9 for storing and transporting. In this method, mask blanks 22 are contaminated in the packing case 9. The packing case 9 includes a rectilinear box 90 having an upper open end 92, and a closure 94 for closing the upper open end 92. The rectilinear box 90 has a set of generally U-shaped side holders 10 mounted to opposite side walls 96 and 96 thereof at equal intervals. Each side holder 10 includes a pair of opposing right side holding portion 102 and left side holding portion 104 projecting inwards from respective side walls 96 and 96. Adjacent right side holding portions 102 and 102 define mask blank receiving gaps 109 as well as adjacent left side holding portions 104 and 104. A pair of lower holding rails 11 and 11 are longitudinally mounted on web portions 106 of the side holders 10, the web portions 106 being mounted on a bottom 98 of the rectilinear box 90. Each of the lower holding rails 11 has mask blank receiving recesses 110 formed in it in an equi-spaced manner. A fluorine containing material 24 is applied on the surfaces of the mask blank receiving recesses 110 of the lower holding rails 11. The closure 94 is provided on its inner surface with a pair of upper holding rails 12 and 12 longitudinally extending.

To apply the fluorine containing material 24 to mask blanks 22, opposite side edges of each of the mask blanks 22 are inserted into respective gaps 109 defined between adjacent side holders 10 and 10, and then each mask blank 22 is fitted at its lower edge into corresponding one of mask blank receiving recesses 110 and 110 of the lower holding rails 11 and 11. Thereafter, the closure 94 is placed on the upper open end 92 of the rectilinear box 90, so that the upper holding rails 12 hold the upper edges of the mask blanks 22. Thus, the fluorine containing material 24 adheres to portions of the mask blanks 22, the portions corresponding to exposed zones 3a. The mask blanks 22 are allowed to stand in this condition for a predetermined period, one week, for example. The portions of the resulting mask blanks 22 are contaminated with the fluorine containing material 24 and hence have deteriorated wettability which does not allow an electron beam resin to coat over those portions. Then, the resist is applied over each of the resulting mask blanks 22 by means of a conventional sealed type resist applying device in the atmosphere of a solvent of the resist. As a result, photoplates 1 each having a pair of exposed zones 3a and 3a are produced as shown in FIG. 6. Then, the fluorine containing material 24 of the photoplates 1 is removed by washing.

The present invention is illustrated in FIG. 7, in which in a conventional manner, a glass substrate 2 is polished at its one surface, washed and then coated with a chromium film 3. The resulting mask blank is conventionally washed. Then, in the present invention, the washed mask is contaminated with a gas mixture 14 in the following manner as shown in FIG. 8. The gas mixture 14 contains a wettability deteriorating gas, such as a gas mixture consisting of 1,1,1-trichloroethane (80% by weight) as solvent and a fine powder of polytetrafluoroethylene (20% by weight). The gas mixture 14 deteriorates wettability of an electron beam resin to the chromium film 3. The gas mixture 14 is pumped by a pumping unit (not shown) and is injected against portions of the upper surface of the chromium film 3 through nozzles 13 and 13 (only one of which is shown in FIG. 8) to form wettability deteriorated zones 3b and 3b. The flow rate of the gas mixture 14 is controlled by a controlling unit (also not shown). Thus, the wettability deteriorated zones 3b and 3b to which the wettability deteriorating gas adheres are formed in the portions corresponding to exposed zones 3a and 3a. Immediately after the contamination with the wettability deteriorating gas, an electron beam resist is conventionally applied to the resulting upper surface of the chromium film 3 with the wettability deteriorated zones 3b and 3b in it. The wettability deteriorating gas which adheres to the exposed zones 3a and 3a prevents the resist from coating over the exposed zones 3a and 3a, so that the exposed zones 3a and 3a are formed in the chromium film 3 of the photoplate 1. Then, the exposed zones 3a and 3a are washed to remove the wettability deteriorating gas which adheres to it.

According to the present invention, the exposed zones of the electrically conductive opaque film are positively produced in the photoplate, and hence sufficient electric contact of the conductive opaque film with earthing members is ensured. Thus, a single earthing member is sufficient for earthing the photoplate or for detecting electrical characteristics thereof.

The exposed zones of the conductive opaque film of the photoplate are according to the present invention easily and positively formed by deteriorating portions of the conductive film of the mask blank in wettability to a coating resin without using any complicated equipment or without additional complex steps.

In the present invention, the pattern forming area of the conductive opaque film is not adversely affected by forming the exposed zones as in the edge cutting method of the prior art. The wettability deteriorating material of the conductive opaque film may be removed in washing the photomask after forming the pattern.

## Claims

1. A method of fabricating a photoplate (1), in which a mask blank, having a glass substrate (2) and an electrically conductive opaque film (3) coating over an upper surface of the glass substrate (2), is coated with a resist to form a resist film (4) over the opaque film (3) to produce the photoplate (1), whereby the photoplate (1) has a zone (3a) of the opaque film (3) exposed for earthing, without being covered with resist,
***characterized in that***
before applying the resist over the opaque film (3), a zone of an upper surface of the opaque film (3) is deteriorated in wettability to the resist so that the resist does not adhere to the deteriorated wettability zone (3a), the deteriorated wettability zone (3a) being away from a pattern forming area (la) of the opaque film (3), and in that after forming the deteriorated wettability zone, the resist is applied over the upper surface of the opaque film (3) to form the resist film (4), whereby the wettability deteriorated zone (3a) of the opaque film (3) is exposed, wherein the wettability deteriorating material includes a wettability deteriorating gas mixture or gas-powder mixture (14) including fluorine, and wherein the wettability deteriorating material putting step comprises injecting the wettability deteriorating gas a gas-powder mixture (14) against the zone of the upper surface of the opaque film (3) for forming the wettability deteriorated zone (3a).

2. A method according to claim 1,
characterized in that
the wettability deteriorating gas mixture (14) consists of 1,1,1-trichloroethane as solvent and a fine powder of polytetrafluoroethylene.

## Patentansprüche

1. Verfahren zur Herstellung einer Fotoplatte (1), bei welchem eine Leermaske, welche ein Glassubstrat (2) und eine elektrisch leitfähige Dunkelschicht (3) hat, die eine obere Oberfläche des Glassubstrats (2) bedeckt, mit einem Resist bedeckt wird, zur Bildung einer Resistschicht (4) auf der Dunkelschicht (3), um eine Fotoplatte (1) zu erzeugen, wobei die Fotoplatte (1) eine Zone (3a) der Dunkelschicht (3) hat, die, ohne mit Resist bedeckt zu sein, für die Erdung freigelegt ist,
dadurch gekennzeichnet, daß
vor dem Aufbringen des Resists auf der Dunkelschicht (3), eine Zone einer oberen Oberfläche der Dunkelschicht (3) in ihrer Benetzbarkeit gegenüber dem Resist so verschlechtert wird, daß der Resist nicht an der Zone (3a) verschlechterter Benetzbarkeit anhaftet, wobei die Zone (3a) verschlechterter Benetzbarkeit sich außerhalb eines Musterbildungsgebiets (1a) der Dunkelschicht (3) befindet, und nach dem Bilden der Zone verschlechterter Benetzbarkeit der Resist der oberen Oberfläche der Dunkelschicht (3) zur Bildung der Resistschicht (4) aufgebracht wird, wobei die Zone (3a) verschlechterter Benetzbarkeit der Dunkelschicht (3) freigelegt wird, wobei das die Benetzbarkeit verschlechternde Material eine die Benetzbarkeit verschlechternde Gasmischung oder Gas-Pulvermischung (14) enthält, die Fluor enthält, wobei der Schritt zur Aufbringung des die Benetzbarkeit verschlechternden Materials umfaßt, daß die die Benetzbarkeit verschlechternde Gasmischung oder Gas-Pulvermischung (14) gegen die Zone der oberen Oberfläche der Dunkelschicht (3) zur Bildung der Zone (3a) verschlechterter Benetzbarkeit gespritzt wird.

2. Verfahren nach Anspruch 1, dadurch gekennzeichnet, daß die die Benetzbarkeit verschlechternde Gasmischung (14) aus 1,1,1-Trichlorethan als Lösungsmittel und einem feinem Pulver aus Polytetrafluorethylen besteht.

## Revendications

1. Procédé de fabrication d'un photomasque (1), dans lequel, une ébauche de masque, ayant un substrat (2) en verre et un revêtement de film opaque (3) conducteur de l'électricité sur une surface supérieure du substrat (2) en verre, est revêtu d'une réserve pour former un film (4) de réserve sur le film opaque (3) pour produire le photomasque (1), grâce à quoi le photomasque (1) possède une zone (3a) du film opaque (3) exposé pour une mise à la terre, sans être recouverte de la réserve,
caractérisé en ce que
avant l'application de la réserve sur le film opaque (3), une zone de la surface supérieure du film opaque (3) est détériorée en ce qui concerne son aptitude à être mouillé par la réserve de sorte que la réserve n'adhère pas à la zone (3a) d'aptitude au mouillage détériorée, la zone (3a) d'aptitude au mouillage détériorée étant éloignée d'une zone (1a) formant un motif du film opaque (3), et en ce qu'après la formation, de la zone d'aptitude au mouillage détériorée, la réserve est appliquée sur la surface supérieure du film opaque (3) pour former le film (4) de réserve, grâce à quoi la zone (3a) d'aptitude au mouillage détériorée du film opaque (3), est mise à nu, dans lequel la matière détériorant l'aptitude au mouillage comprend un mélange gazeux ou un mélange gaz-poudre détériorant l'aptitude au mouillage (14) contenant du fluor, et dans lequel l'étape de dépôt de la matière détériorant l'aptitude au mouillage consiste à injecter le mélange gazeux ou le mélange gaz-poudre détériorant l'aptitude au mouillage (14) contre la zone de la surface supérieure du film opaque (3) pour former la zone (3a) d'aptitude au mouillage détériorée.

2. Procédé selon la revendication 1,
caractérisé en ce que
le mélange gazeux détériorant l'aptitude au mouillage (14) se compose de 1,1,1-trichloroéthane en tant que solvant et d'une poudre fine de polytétrafluoroéthylène.
